# EUROPEAN PATENT SPECIFICATION

(11) **EP 3 098 871 B1**
(45) Date of publication and mention of the grant of the patent: **02.01.2019**
(21) Application number: 14880101.2
(22) Date of filing: 19.03.2014
(51) Int. Cl.: H01L 51/46, H01G 9/20, C01G 21/16, C01G 21/00

(54) **PEROVSKITE PHOTOELECTRIC FUNCTIONAL MATERIAL MODIFIED WITH AMPHIPATHIC MOLECULE AND USE THEREOF**
PHOTOELEKTRISCHES PEROWSKIT-FUNKTIONSMATERIAL MIT AMPHIPATHISCHEN MOLEKÜLEN UND VERWENDUNG DAVON
MATÉRIAU FONCTIONNEL PHOTOÉLECTRIQUE DE PÉROVSKITE MODIFIÉ AVEC UNE MOLÉCULE BIPOLAIRE ET SON UTILISATION

(30) Priority: 21.01.2014 CN 201410027583
(43) Date of publication of application: 30.11.2016
(73) Proprietor: Wonder Solar Limited Liability Company, Ezhou Hubei 436000 (CN)
(72) Inventor: HAN, Hongwei, Wuhan Hubei 430074 (CN); MEI, Anyi, Wuhan Hubei 430074 (CN)
(74) Representative: Hryszkiewicz, Danuta
(86) International application number: PCT/CN2014/073653
(87) International publication number: WO 2015/109647

(56) References cited:
- CN-A- 1 316 427
- CN-A- 103 346 018
- CN-A- 103 400 697
- CN-A- 103 474 574
- US-A- 5 871 579
- D. B. MITZI ET AL: "Conducting tin halides with a layered organic-based perovskite structure", NATURE, vol. 369, no. 6480, 9 June 1994 (1994-06-09), pages 467-469, XP055045570, ISSN: 0028-0836, DOI: 10.1038/369467a0
- ZIYONG CHENG ET AL: "Layered organic-inorganic hybrid perovskites: structure, optical properties, film preparation, patterning and templating engineering", CRYSTENGCOMM, vol. 12, no. 10, 6 July 2010 (2010-07-06), page 2646, XP055045568, ISSN: 1466-8033, DOI: 10.1039/c001929a

## Description

The invention relates to a perovskite-based photoelectric functional material M_{z}A_{y}BX_{z+y+2} and the use thereof, which belongs to the technical field of electronic devices.

New renewable energy should be developed as an alternative to traditional fossil energy due to an increasing demand for energy and a decreasing reservation of traditional fossil energy. New energy studied and utilized at present comprises wind, geothermal, nuclear, solar energy, etc.. However, wind and geothermal energy are greatly restricted by geographical locations, nuclear energy has great potential security risk and raw materials are non-renewable. So, solar energy attracts more attention for being inexhaustible and free from pollution. The use of solar energy mainly covers photothermal, photochemical and photovoltaic conversion. But promotion and application of photothermal and photochemical conversion are hindered by various reasons, and photovoltaic conversion (namely solar cells) is widely studied for its unique advantages. Nowadays, silicon-based solar cells play a dominant role in solar cells although they have high cost in raw materials and complex production process. Therefore, it is quite necessary to develop new photovoltaic conversion materials with low cost and simple preparation process.

ABX₃-structured perovskite materials have aroused increasing attention due to its unique crystal structure and high photovoltaic conversion efficiency. The material has quite high carrier mobility, cavity concentration and a wide spectrum response range with a strong absorption in 300-800 nm. Besides, electrons and cavities have a long life in ABX₃-structured perovskite materials with a diffusion length up to 100 nm, which facilitates the charge separation. Therefore, solar cells based on ABX₃-structured perovskite materials prepared by a full-solution method become a hot spot for researchers after being reported reaching a photovoltaic conversion efficiency of 9.7% in August, 2012. Then the efficiency thereof is improved from 9.7% to 14.1% and even to 16.4% through process optimization only after one year. These results pave the way for studies of solar cells with low cost and high efficiency.

Mitzl et al., "Conducting tin halides with a layered organic-based perovskite structure," Letter to Nature, Vol 369, June 1994, pages 467-469 recites an organic-based perovskite structure having a formula of (C₄H₉NH₃)₂(CH₃NH₃)ₙ₋₁SnₙI₃ₙ₊₁, and a method of synthesizing the same.

US 5871579A recites a two-step dipping technique for preparing thin films of layered organic-inorganic perovskites having a formula of (RNH₃)₂(CH₃NH₃)ₙ₋₁MnI₃₊₁ where R represents butyl or phenethyl, M represents Pb, Sn, and n equals to 1 or 2.

Although the application of ABX₃-structured perovskite materials in solar cells has made great progress, their drawbacks in the control of crystallization during the preparation by a full-solution method restrict the efficiency and stability of perovskite solar cells, and the methods like vacuum vapor deposition increase the cost greatly and limit the application in spite of favoring the control of crystallization.

In view of the above-mentioned problems, it is an objective of the invention to provide a perovskite-based photoelectric functional material modified with an organic amphipathic molecule. This material has excellent photovoltaic performance and high stability and can be easily prepared from a wide source of low-cost raw materials. Also, it is advantageous in improving efficiency and stability of solar cells in the field of perovskite-based solar cells.

To achieve the above objective, according to one embodiment of the present invention, there is provided a perovskite-based photoelectric functional material modified with an organic amphipathic molecule, expressed by a general formula M_{z}A_{y}BX_{z+y+2}, according to claim 1.

In a class of this embodiment, the organic amphipathic molecule M is expressed by R1-R-R2, R1 is selected from a group consisting of -NH₂, -NH-C(NH₂)=NH and -N=CH-NH₂.

In a class of this embodiment, R2 in the organic amphipathic molecule R1-R-R2 is selected from a group consisting of-COOH, -OSiOH, -O₃POH and -O₂SOH.

In a class of this embodiment, R in the organic amphipathic molecule R1-R-R2 is an organic group and could be selected from a group consisting of linear alkyl, branched alkyl and halogenated alkyl of C1-C30, cycloalkyl of C3-C12, heterocycle of C1-C12, alkenyl of C2-C8, alkynyl of C2-C8, aryl of C6-C12, aryl-substituted alkyl group of C6-C30, alkylaryl of C6-C30, heteroaryl of C1-C12, alkyl heteroaryl of C6-C30 and alkyl heterocycle of C6-C30.

In a class of this embodiment, A is selected from a group consisting of methylamine, formamidine and cesium preferably.

In a class of this embodiment, B is selected from a group consisting of lead, tin, copper and germanium.

In a class of this embodiment, X is selected from a group consisting of chlorine, bromine and iodine.

According to another embodiment of the present invention, there is provided an application of the perovskite-based photoelectric functional material modified with an organic amphipathic molecule in solar cells, the perovskite-based photoelectric functional material is used as a light absorption layer, n-type or p-type materials.

According to another embodiment of the present invention, there is provided an application of the perovskite-based photoelectric functional material modified with an organic amphipathic molecule in other fields such as LEDs and electronic devices.

According to another embodiment that does not fall under the invention, there is provided a preparation method of the perovskite-based photoelectric functional material, the method comprising:
(1) contacting an amphipathic molecule with hydrohalic acid to yield a solution comprising a salt of halogen oxoacid;
(2) contacting an appropriate amount of said solution comprising a salt of halogen oxoacid and methylammonium iodide with PbI₂ to yield a perovskite precursor solution; and
(3) drying said perovskite precursor solution to yield said perovskite-based photoelectric functional material.

Preferably, the amphipathic molecule is mixed with hydrohalic acid in an ice-water bath, evaporated, washed with ether, and precipitates to yield the solution comprising a salt of halogen oxoacid.

Preferably, the perovskite precursor solution is obtained by adding an appropriate amount of γ-butyrolactone into iodate, methylammonium iodide and PbI₂ with a certain molar ratio and stirring the mixture for fully reaction.

A significant advantage of the invention is: promoting crystalline morphology of a perovskite material ABX₃ by using organic amphipathic molecules that are low cost and have extensive sources to greatly improve the crystallization performance, which induced an increased photoelectric conversion efficiency and stability of perovskite material-based solar cells significantly.

The material of the invention has excellent photovoltaic properties and high stability and can be prepared by a simple method with simple apparatuses from raw materials that are low cost and have extensive sources.

As M is 4-aminobutyric acid, A is methylamine, B is lead, X is chlorine, x is 0.1, and y is 0.95, carbon-materials-based counter electrode mesoscopic solar cells that used MₓA_{y}BX_{x+y+2} show excellent stability, and the photovoltaic conversion efficiency can reach up to 11%, far greater than that of solar cells in the same kind. The photoelectric functional material MₓA_{y}BX_{x+y+2} of the invention has a greater prospect for industrial applications compared with the existing perovskite material ABX₃.

Prepared by a full-solution method, the photoelectric functional material modified with an organic amphipathic molecule with a perovskite material ABX₃ as the matrix of the invention is far superior to an unmodified material in photovoltaic conversion efficiency and stability, and crystalizing performance when applied it to solar cells. Under the same circumstance, applying the photoelectric functional material MₓA_{y}BX_{x+y+2} to carbon-materials-based counter electrode mesoscopic solar cells results in higher photovoltaic conversion efficiency and stability than applying the unmodified material ABX₃ to solar cells in the same kind.

For further illustrating the invention, experiments detailing a perovskite-based photoelectric functional material M_{z}A_{y}BX_{z+y+2} and a preparation method thereof are described below. It should be noted that the following examples are intended to describe and not to limit the invention.

According to one embodiment of the invention, there is provided a perovskite-based photoelectric functional material modified with an organic amphipathic molecule, expressed by a general formula M_{z}A_{y}BX_{z+y+2}, where M is an organic amphipathic molecule used as a modification component with a perovskite material ABX₃ as a matrix.

The organic amphipathic molecule M is expressed by R1-R-R2, R1 is selected from a group consisting of -NH₂, -NH-C(NH₂)=NH and -N=CH-NH₂, and R2 is selected from a group consisting of -COOH, -OSiOH, -O₃POH and -O₂SOH.

In this embodiment, R is an organic group and is selected from a group consisting of linear alkyl, branched alkyl and halogenated alkyl of C1-C30, cycloalkyl of C3-C12, heterocycle of C1-C12, alkenyl of C2-C8, alkynyl of C2-C8, aryl of C6-C12, aryl-substituted alkyl group of C6-C30, alkylaryl of C6-C30, heteroaryl of C1-C12, alkyl heteroaryl of C6-C30 and alkyl heterocycle of C6-C30.

In this embodiment, A is selected from a group consisting of methylamine, formamidine and cesium preferably.

In this embodiment, B is selected from a group consisting of lead, tin, copper and germanium preferably.

In this embodiment, X is selected from a group consisting of chlorine, bromine and iodine preferably.

In the photoelectric functional material MₓA_{y}BX_{x+y+2}, 0<z≤0.5, 0<y≤1, and y+z≥1, and z=0.01-0.1 and y=0.95-1 preferably.

When no amphipathic molecule is introduced, monovalent ions such as short-chained amine cations (such as methylamine and formamidine) and cesium ions enter gaps among co-vertex connected octahedrons of a metal halide BX₂ to form a 3D perovskite material. When an amphipathic molecule is introduced, short-chained amine cations or cesium ions enter gaps among co-vertex connected octahedrons of the metal halide to form 3D perovskite layers (thickness of each perovskite layer is determined by molar ratio between the amphipathic molecule and the monovalent ion), and an organic layer is generated between every two 3D perovskite layers to obtain a modified perovskite material with perovskite layers and organic layers overlapped alternatively. Film quality in a large area and stability of the material is significantly improved and photovoltaic properties thereof are optimized due to the existence of organic amphipathic molecules.

According to one embodiment that does not fall under the invention, there is provided a preparation method of a perovskite-based photoelectric functional material modified with an organic amphipathic molecule, comprising steps of:
1) Obtaining a solution comprising a salt of halogen oxoacid by an amphipathic molecule reacting with hydrohalic acid; Specifically and preferably, an iodate is obtained by an amphipathic molecule M fully reacting with hydroiodic acid into an ice-water bath, rotary evaporation, and washing the precipitate with diethyl ether.
2) Obtaining a perovskite precursor solution by an appropriate amount of the solution comprising a salt of halogen oxoacid and methylammonium iodide reacting with PbI₂;

Specifically and preferably, a precursor solution is obtained by adding an appropriate amount of γ-butyrolactone into iodate, methylamine iodide and PbI₂ weighted respectively by molar ratio and stirring the mixture for fully reaction.

3) Drying the perovskite precursor solution thereby obtaining the perovskite-based photoelectric functional material.

### Example 1

In this example, an amphipathic molecule 4-aminobutyric acid (GABA) is fully reacted with hydroiodic acid into an ice-water bath with a molar ratio of 1:1. After rotary evaporation, the precipitate is washed by diethyl ether thoroughly and the (GABA)I powder is obtained. Then, (GABA)I, methylammonium iodide and PbI₂ are mixed with a molar ratio of 0.1:0.95:1 and an appropriate amount of γ-butyrolactone is added and stirred for fully reaction to obtain the (GABA)_{0.1}MA_{0.95}PbI_{3.05} precursor solution. An appropriate amount of the precursor solution is filled into a carbon-materials-based counter electrode mesoscopic solar cell and dried at 50°C and photovoltaic conversion efficiency of the solar cell is up to 11%.

### Example 2

In this example, an amphipathic molecule 4-aminobutyric acid (GABA) is fully reacted with hydrochloric acid into an ice-water bath with a molar ratio of 1:1. After rotary evaporation, the precipitate is washed by diethyl ether thoroughly and the (GABA)CI powder is obtained. Then, (GABA)CI, methylammonium iodide and PbI₂ are mixed with a molar ratio of 0.06:0.97:1 and an appropriate amount of DMF is added and stirred for fully reaction to obtain the (GABA)_{0.06}MA_{0.97}PbI_{2.97}Cl_{0.06} precursor solution. An appropriate amount of the precursor solution is filled into a carbon-materials-based counter electrode mesoscopic solar cell and dried at 70°C and photovoltaic conversion efficiency of the solar cell is up to 11%.

### Example 3

In this example, an amphipathic molecule 4-aminobutyric acid (GABA) is fully reacted with hydroiodic acid into an ice-water bath with a molar ratio of 1:1. After rotary evaporation, the precipitate is washed by diethyl ether thoroughly and the (GABA)I powder is obtained. Then, (GABA)I, methylamine bromide and PbI₂ are mixed with a molar ratio of 0.1:0.95:1 and an appropriate amount of γ-butyrolactone is added and stirred for fully reaction to obtain the (GABA)_{0.1}MA_{0.95}PbI_{2.1}Br_{0.95} precursor solution. An appropriate amount of the precursor solution is filled into a carbon-materials-based counter electrode mesoscopic solar cell and dried at 60°C and photovoltaic conversion efficiency of the solar cell is up to 9.8%.

In the above examples, the amphipathic molecule is not limited to 4-aminobutyric acid and can also be other material, such as 6-aminocaproic acid, HOOC-CH₂-CH=CH-CH₂-NH₂, 4-guanidinobutyric acid or sulfanilic acid. Generally, M is expressed by R1-R-R2, R1 is selected from the group consisting of -NH₂, -NH-C(NH₂)=NH and -N=CH-NH₂, R2 is selected from the group consisting of -COOH, -OSiOH, -O₃POH and -O₂SOH, and R is an organic group.

Besides, methylammonium iodide can be replaced by chloride methylamine or bromide methylamine, PbI₂ can be replaced by lead bromide, lead chloride, germanium iodide or tin iodide, and molar ratio is not limited to the above values as long as 0<z≤0.5, 0<y≤1 and y+z≥1.

The perovskite-based photoelectric functional material of the invention can be used in a solar cell as a light absorption layer, n-type or p-type materials, and can also be used in LEDs or electronic devices as a semiconductor material.

## Claims

1. A perovskite-based photoelectric material having a general formula of M_{z}A_{y}BX_{z+y+2}, A representing a monovalent ion, B representing a divalent metal ion, and X representing a halide ion; **characterized in that**
0<z≤0.5, 0<y≤1, and y+z≥1;
M represents an organic molecule having a formula of R1-R-R2;
R1 is selected from a group consisting of -NH₂, -NH-C(NH₂)=NH, and -N=CH-NH₂;
R2 is selected from a group consisting of -COOH, -OSiOH represented by Formula I, -O₂SOH represented by Formula II, and - O₃POH represented by Formula III; 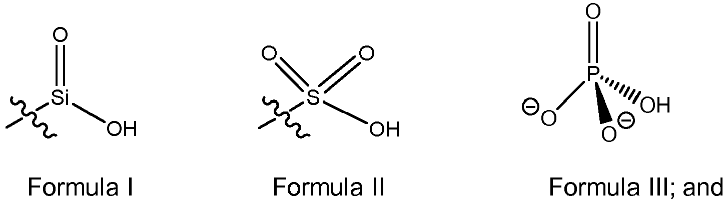
R is an organic group.

2. The material of claim 1, **characterized in that** A is an organic ammonium cation or an alkali metal ion, and A is selected from a group consisting of methylammonium cation, formamidinium cation, and caesium cation.

3. The material of any one of claims 1-2, **characterized in that** B is selected from a group consisting of lead ion, tin ion, copper ion and germanium ion.

4. The material of any one of claims 1-3, **characterized in that** R is selected from a group consisting of linear alkyl, branched alkyl and halogenated alkyl of C1-C30, cycloalkyl of C3-C12, heterocycle of C1-C12, alkenyl of C2-C8, alkynyl of C2-C8, aryl of C6-C12, aryl-substituted alkyl group of C6-C30, alkylaryl of C6-C30, heteroaryl of C1-C12, alkyl heteroaryl of C6-C30 and alkyl heterocycle of C6-C30.

5. A use of the perovskite-based photoelectric material of any one of claims 1-4 in solar cells, wherein said perovskite-based photoelectric material is used as a light absorption layer, n-type or p-type materials, or in LEDs or electronic devices as a semiconductor material.

## Patentansprüche

1. Photoelektrisches Material auf Perowskitbasis mit einer allgemeinen Formel von M_{z}A_{y}BX_{z+y+2}, wobei A ein monovalentes Ion darstellt, B ein divalentes Metallion darstellt und X ein Halogenidion darstellt; **dadurch gekennzeichnet, dass**
0<z≤0,5, 0<y≤1 und y+z≥1;
M ein organisches Molekül mit der Formel R1-R-R2 darstellt;
R1 ausgewählt ist aus einer Gruppe, bestehend aus -NH₂, -NH-C(NH₂)=NH, und -N=CH-NH₂;
R2 ausgewählt ist aus einer Gruppe, bestehend aus -COOH, - OSiOH, dargestellt durch Formel I, -O₂SOH, dargestellt durch Formel II, und -O₃POH, dargestellt durch Formel III; 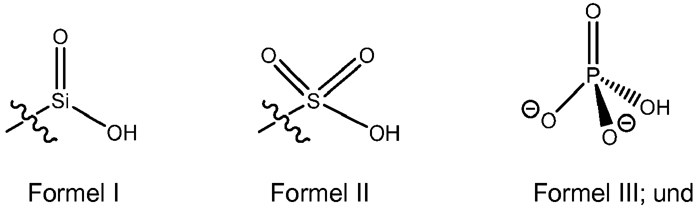
R eine organische Gruppe ist.

2. Material nach Anspruch 1, **dadurch gekennzeichnet, dass** A ein organisches Ammoniumkation oder ein Alkalimetallion ist und A ausgewählt ist aus einer Gruppe, bestehend aus Methylammoniumkation, Formamidiniumkation und Caesiumkation.

3. Material nach einem der Ansprüche 1 bis 2, **dadurch gekennzeichnet, dass** B ausgewählt ist aus einer Gruppe, bestehend aus Bleiion, Zinnion, Kupferion und Germaniumion.

4. Material nach einem der Ansprüche 1 bis 3, **dadurch gekennzeichnet, dass** R ausgewählt ist aus einer Gruppe, bestehend aus linearem Alkyl, verzweigtem Alkyl und halogeniertem Alkyl von C1-C30, Cycloalkyl von C3-C12, Heterozyklus von C1-C12, Alkenyl von C2-C8, Alkinyl von C2-C8, Aryl von C6-C12, arylsubstituierter Alkylgruppe von C6-C30, Alkylaryl von C6-C30, Heteroaryl von C1-C12, Alkylheteroaryl von C6-C30 und Alkylheterozyklus von C6-C30.

5. Verwendung des photoelektrischen Materials auf Perowskitbasis nach einem der Ansprüche 1 bis 4 in Solarzellen, wobei das photoelektrische Material auf Perowskitbasis als eine Lichtabsorptionsschicht, als n-Typ- oder p-Typ-Material oder in LEDs oder elektronischen Vorrichtungen als Halbleitermaterial verwendet wird.

## Revendications

1. Matériau photoélectrique à base de pérovskite ayant une formule générale M_{z}A_{y}BX_{z+y+2}, A représentant un ion monovalent, B représentant un ion métallique divalent, et X représentant un ion halogénure ; **caractérisé en ce que**
0 < z ≤ 0,5, 0 < y ≤ 1, ety + z ≥ 1 ;
M représente une molécule organique ayant une formule de R1-R-R2;
R1 est sélectionné dans un groupe constitué de -NH₂, -NH-C(NH₂)=NH, et -N=CH-NH₂ ;
R2 est sélectionné dans un groupe constitué de -COOH, -OSiOH représenté par la formule I, -O₂SOH représenté par la formule II, et - O₃POH représenté par la formule III ; 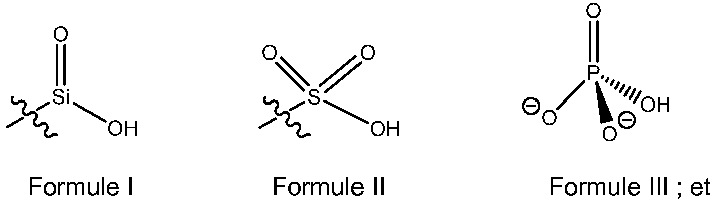
R est un groupe organique.

2. Matériau selon la revendication 1, **caractérisé en ce que** A est un cation ammonium organique ou un ion de métal alcalin, et A est sélectionné dans un groupe constitué d'un cation méthylammonium, d'un cation formamidinium, et d'un cation césium.

3. Matériau selon l'une quelconque des revendications 1 et 2, **caractérisé en ce que** B est sélectionné dans un groupe constitué d'un ion plomb, d'un ion étain, d'un ion cuivre et d'un ion germanium.

4. Matériau selon l'une quelconque des revendications 1 à 3, **caractérisé en ce que** R est sélectionné dans un groupe constitué d'un groupe alkyle linéaire, d'un groupe alkyle ramifié et d'un groupe alkyle halogéné en C1 à C30, d'un groupe cycloalkyle en C3 à C12, d'un groupe hétérocycle en C1 à C12, d'un groupe alcényle en C2 à C8, d'un groupe alcynyle en C2 à C8, d'un groupe aryle en C6 à C12, d'un groupe alkyle en C6 à C30 substitué par un groupe aryle, d'un groupe alkylaryle en C6 à C30, d'un groupe hétéroaryle en C1 à C12, d'un groupe alkyl hétéroaryle en C6 à C30 et d'un groupe alkyl hétérocycle en C6 à C30.

5. Utilisation d'un matériau photoélectrique à base de pérovskite selon l'une quelconque des revendications 1 à 4 dans des cellules solaires, dans laquelle ledit matériau photoélectrique à base de pérovskite est utilisé en tant que couche d'absorption de lumière, matériaux de type n ou de type p, ou dans des DEL ou des dispositifs électroniques en tant que matériau semi-conducteur.
